# FASCICULE DE BREVET EUROPEEN

(11) **EP 2 666 194 B1**
(45) Date de publication et mention de la délivrance du brevet: **04.04.2018**
(21) Numéro de dépôt: 11811050.1
(22) Date de dépôt: 08.12.2011
(51) Int. Cl.: H01L 51/00, H01L 51/10

(54) **PROCEDE DE GRAVURE DE COUCHES MICRO-ELECTRIQUES PAR UN FAISCEAU LASER**
VERFAHREN ZUM ÄTZEN MIKROELEKTRONISCHER FILME MITTELS EINES LASERSTRAHLS
METHOD FOR ETCHING MICRO-ELECTRICAL FILMS USING A LASER BEAM

(30) Priorité: 17.01.2011 FR 1150350
(43) Date de publication de la demande: 27.11.2013
(73) Titulaire: Commissariat à l'Énergie Atomique et aux Énergies Alternatives, 75015 Paris (FR)
(72) Inventeur: SEILER, Anne-Laure, 38170 Seyssinet Pariset (FR); BENWADIH, Mohammed, 94500 Champigny Sur Marne (FR)
(74) Mandataire: Cabinet Laurent & Charras
(86) Numéro de dépôt international: PCT/FR2011/052902
(87) Numéro de publication internationale: WO 2012/098302

(56) Documents cités:
- US-A1- 2007 040 169
- KIM S-J ET AL: "LOW-LEAKAGE POLYMERIC THIN-FILM TRANSISTORS FABRICATED BY LASER ASSISTED LIFT-OFF TECHNIQUE", JAPANESE JOURNAL OF APPLIED PHYSICS, JAPAN SOCIETY OF APPLIED PHYSICS, JP, vol. 44, no. 33-36, 1 janvier 2005 (2005-01-01), pages L1109-L1111, XP001238049, ISSN: 0021-4922, DOI: 10.1143/JJAP.44.L1109

## Description

### DOMAINE DE L'INVENTION

L'invention a trait au domaine de la gravure laser, telle que mise en oeuvre lors de procédés de fabrication de composants microélectroniques.

### ETAT DE LA TECHNIQUE

La gravure laser est un procédé connu pour ôter une couche de matériau déposée à la surface d'un autre matériau. En irradiant la couche de matériau à ôter, l'énergie électromagnétique échauffe superficiellement cette dernière, puis la chaleur se propage jusqu'à l'interface entre les deux matériaux où elle s'accumule jusqu'à ce qu'il se forme une cloque. La couche de matériau à ôter se décolle ainsi du matériau sur lequel elle est déposée.

L'énergie nécessaire au décollement caractérisée par la fluence reçue du laser, la durée d'irradiation et la longueur d'onde du laser, ou de manière équivalente par la puissance surfacique, la durée d'irradiation et la longueur d'onde du laser, dépend des caractéristiques de la couche de matériau à ôter et des caractéristiques du matériau sur lequel ladite couche est déposée. Il convient donc d'adapter les propriétés du laser à chaque cas particulier.

Or, il est fréquent qu'une couche de matériau à ôter soit déposée sur deux matériaux différents. Par exemple, lors de la fabrication d'un transistor organique, les électrodes métalliques de drain et de source, usuellement en or, sont déposées sur un substrat en plastique, puis une couche de semi-conducteur organique d'une centaine de nanomètres d'épaisseur est déposée en recouvrant le tout. A ce stade de la fabrication, les électrodes nécessitent alors d'être dégagées. Cependant, en irradiant la couche de semi-conducteur avec une fluence et une durée d'irradiation choisies pour décoller la portion de couche de semi-conducteur déposée sur le substrat en plastique, on détériore également les électrodes métalliques, voire même on décolle celles-ci du substrat en plastique.

Ainsi par exemple, pour décoller une couche de semi-conducteur de 100 nanomètres déposée sur un substrat en polyéthylène naphtalate (PEN), il faut au minimum une fluence de 70 mJ/cm² pour une irradiation de 30 nanosecondes avec un laser à 245 nanomètres. Or, une telle irradiation est incompatible avec des électrodes de drain et de source en or déposées sur le substrat puisque ces électrodes sont détériorées dès que la fluence est supérieure à 55 mJ/cm². Il est ainsi impossible de décoller à la fois la portion de couche de semi-conducteur déposée sur le substrat en plastique et à la fois la portion de couche de semi-conducteur déposée sur les électrodes métalliques à l'aide d'une seule et même irradiation appliquée sur la totalité de la couche de semi-conducteur organique. Usuellement, cette couche est donc ôtée à l'aide d'un traitement chimique, qui présente l'inconvénient de laisser des résidus. La demande US 2007/0040169 A1 divulgue un procédé de fabrication d'un transistor organique. L'exposition d'une couche photosensible à une irradiation UV provoque l'ablation d'une zone de ladite couche, en entraînant avec elle une portion d'une couche supérieure située sur ladite couche photosensible.

### EXPOSE DE L'INVENTION

Le but de la présente invention est de proposer un procédé de gravure par laser qui abaisse l'énergie du laser nécessaire au décollement d'un premier matériau déposé sur un deuxième matériau, ce qui rend possible notamment le décollement d'un matériau déposé sur deux matériaux différents.

A cet effet, l'invention a pour objet un procédé de gravure par un faisceau laser de longueur d'onde prédéterminée d'une zone d'une couche d'un premier matériau, ladite zone étant déposée à la surface d'au moins deux deuxièmes matériaux, le procédé consistant :
▪ à déposer une couche d'un troisième matériau sur la couche de premier matériau, le premier et le troisième matériau présentant une affinité chimique lors de l'application du faisceau laser supérieure à l'affinité chimique lors de ladite application entre le premier matériau chacun desdits au moins deuxièmes matériaux ; et
▪ à appliquer le faisceau laser sur une zone d'une surface libre de la couche de troisième matériau à l'aplomb de la zone de la couche de premier matériau avec une fluence dudit faisceau laser entrainant le décollement de ladite zone. Selon le procédé de l'invention, le premier matériau est un matériau semiconducteur organique et les deuxièmes matériaux sont respectivement un matériau plastique et un matériau conducteur. En d'autres termes, il a pu être observé qu'en déposant sciemment une couche qui adhère sur la couche de premier matériau plus fortement que la couche de premier matériau n'adhère sur les deuxièmes matériaux, l'énergie minimale nécessaire au décollement de la couche de premier matériau est plus faible.

Comme précédemment décrit, pour décoller une couche de matériau semi-conducteur de 100 nanomètres déposée sur une couche de PEN en irradiant directement la couche de matériau semi-conducteur, il est nécessaire de prévoir une fluence d'au moins de 70 mJ/cm² pour une irradiation de 30 nanosecondes avec un laser à 248 nanomètres.

A titre d'exemple de l'invention, en déposant sur une couche de matériau semi-conducteur organique une couche de 30 nanomètres de polymère fluoré, la fluence minimale nécessaire chute à 50 mJ/cm².

De manière générale, il a pu être observé qu'il y a baisse de l'énergie minimale à appliquer dès lors que l'adhérence entre le troisième matériau et le premier matériau est supérieur à l'adhérence entre le premier matériau et les deuxièmes matériaux.

Selon un mode de réalisation, le laser est un laser excimère.

Selon un mode de réalisation de l'invention, l'épaisseur de la couche de troisième matériau est comprise entre 1 nanomètre et 1 micromètre.

Selon un mode de réalisation de l'invention, le matériau et l'épaisseur de la couche de troisième matériau est choisie en fonction de la fluence et du faisceau laser, du premier matériau et de l'épaisseur de la zone de premier matériau à décoller.

Notamment, le matériau semi-conducteur organique est un polymère fluoré, le matériau conducteur un métal ou un polymère conducteur, et le troisième matériau un polymère fluoré.

Plus particulièrement, le troisième matériau est du CYTOP®, et/ou le premier matériau est du TIPS, et/ou le troisième matériau présente une enthalpie de liaison avec le premier matériau supérieure à 15 kJ.mol⁻¹. En outre, l'épaisseur de la couche de polymère fluoré est sensiblement égale à 100 nanomètres, l'épaisseur de la couche de premier matériau est sensiblement égale à 100 nanomètres, l'épaisseur de la couche de matériau conducteur est sensiblement égale à 30 nanomètres, la fluence du faisceau laser est inférieure à 50 mJ/cm² ; et la durée d'irradiation par le faisceau laser est sensiblement égale à 30 nanosecondes.

Selon un mode de réalisation de l'invention, le troisième matériau a une absorption de longueur d'onde du faisceau laser supérieure à celle du premier matériau.

### BREVE DESCRIPTION DES FIGURES

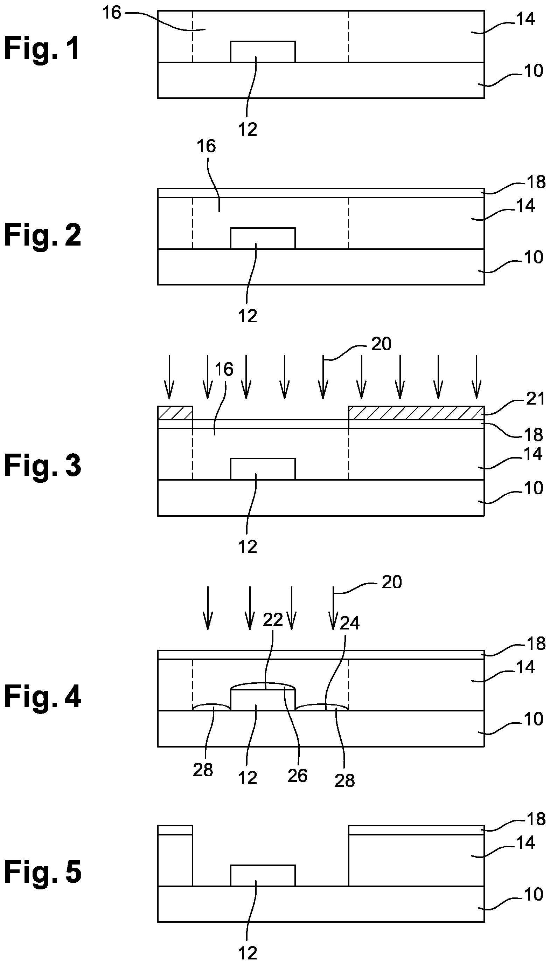

L'invention sera mieux comprise à l'analyse de la description qui va suivre, donnée uniquement à titre d'exemple, et réalisée en relation avec les dessins annexés dans lesquels les figures 1 à 5 sont des vues schématiques en coupe illustrant un procédé de gravure laser selon l'invention appliqué à l'élimination d'une couche de semi-conducteur organique déposée à la fois sur un substrat en plastique et sur une électrode métallique.

### DESCRIPTION DETAILLEE DE L'INVENTION

Il va être décrit une application d'un procédé selon l'invention tendant à l'élimination d'une couche de matériau semi-conducteur organique présente sur et autour d'une électrode métallique déposée sur un substrat en plastique, comme cela est par exemple le cas lors de la fabrication d'un transistor organique au cours de laquelle les électrodes de drain et de source nécessitent d'être dégagées pour la suite de la réalisation du transistor.

La figure 1 illustre donc schématiquement en coupe un empilement obtenu au cours d'un procédé de fabrication d'un transistor organique. Cet empilement comporte un substrat **10** en PEN (polyéthylène naphtalate), sur lequel est déposée une électrode de drain ou de source **12** par exemple en or, le tout étant recouvert d'une couche de matériau semi-conducteur organique **14**, par exemple de la famille des pentacènes, par exemple du TIPS (propylsilylethynyl pentacène), ou des polymères amorphes par exemple du type TFB (dioctyl-florène-butylphenyl-diphenylamine). La couche **14** est donc déposée à la fois sur le substrat en plastique **10** et sur l'électrode métallique **12.** A ce stade de la fabrication, la couche **14** nécessite d'être éliminée dans une zone **16** sur et autour de l'électrode **12.**

Afin d'éliminer la portion **16** de la couche de matériau semi-conducteur **14** à l'aide d'un faisceau laser UV excimère, un procédé selon l'invention débute par le dépôt sur la couche **14** d'une couche de polymère par exemple fluoré **18**, notamment une couche de CYTOP® de Asahi Glass Co. Ltd d'une épaisseur inférieure à 1 000 nanomètres (figure 2).

La couche de polymère fluoré **18** absorbe les UV, et donc le rayonnement issu du laser, et son adhérence à la couche de matériau semi-conducteur **14** augmente très fortement par le développement de liaisons chimiques ayant une forte enthalpie de liaison, par exemple une enthalpie de liaison d'énergie supérieure à 15 kJ.mol⁻¹ dans le cas des liaisons hydrogènes. De manière avantageuse, le matériau semi-conducteur **14** et/ou le matériau de la couche **18** est un polymère fluoré.

Cette forte enthalpie de liaison a notamment pour effet une adhérence plus forte de la couche **18** sur la couche **14** que celle de la couche **14** sur l'électrode **12** et sur le substrat **10.**

Le procédé se poursuit alors par l'irradiation de la portion **16** de la couche semi-conducteur **14** avec un faisceau laser **20** selon une fluence et selon une durée d'irradiation appropriées au décollement de la couche **14** à la fois de l'électrode en or **12** et du substrat en PEN **10**, comme expliqué ci-dessous (figure 3). Un masque **21** est par exemple déposé sur la couche **18** en laissant libre la portion de couche **18** correspond à la portion **16** à ôter et l'irradiation par le faisceau laser **20** est réalisée pleine plaque.

L'énergie électromagnétique incidente s'accumule alors à l'interface **22** entre l'électrode métallique **12** et la couche de matériau semi-conducteur **14** et à l'interface **24** entre la couche de matériau semi-conducteur **14** et le substrat en plastique **10**, de sorte que des cloques **26**, **28**, **30** se forment à ces interfaces **22** et **24** (figure 4).

Une fois que les cloques **26**, **28**, **30** ont atteint une taille critique, le matériau semi-conducteur au dessus de celles-ci se décolle, ce qui a pour résultat de dégager l'électrode métallique **12** sans laisser de résidu de matériau semi-conducteur (figure 5). Le masque **21** et/ou la couche **18** sont ensuite éliminés.

Pour une couche de matériau semi-conducteur **14** de 100 nanomètres d'épaisseur, une électrode métallique **22** de 30 nanomètres d'épaisseur, et un laser ayant une longueur d'onde de 245 nanomètres générant un pulse laser de 30 nanosecondes :
▪ si l'épaisseur de la couche **18** est comprise entre 1 et 50 nanomètres, il faut une fluence minimale comprise entre 30 et 40 mJ.cm² pour décoller la couche semi-conductrice **14** à la fois de l'électrode métallique **12** et du substrat plastique **10.** On n'observe alors aucune dégradation de l'électrode métallique **12**;
▪ si l'épaisseur de la couche **18** est comprise entre 50 et 100 nanomètres, il faut une fluence minimale comprise entre 40 et 50 mJ.cm² pour décoller la couche semi-conductrice **14** à la fois de l'électrode métallique **12** et du substrat plastique **10.** Là encore, aucune dégradation de l'électrode métallique **12** n'est observée ; et
▪ si l'épaisseur de la couche **18** est supérieure à 100 nanomètres, il faut une fluence minimale comprise entre 50 et 70 mJ.cm² pour décoller la couche semi-conductrice **14** à la fois de l'électrode métallique **12** et du substrat plastique **10.** Pour des fluences supérieures à 55 mJ.cm², on observe une dégradation de l'électrode **12.**

En conséquence, l'épaisseur de la couche **18** est choisie inférieure à 100 nanomètres et le faisceau laser est réglé pour une fluence inférieure à 50 mJ.cm².

Cette valeur de la fluence doit être comparée à la valeur de 70 mJ.cm² qui est la fluence minimale nécessaire à l'élimination d'une portion de couche de matériau semi-conducteur déposée sur le substrat plastique **10** en l'absence de la couche **18** en polymère fluoré.

On a ainsi pu observer que le concepteur dispose d'au moins deux paramètres concernant la couche **18** pour régler la fluence du laser sur une valeur qui ne dégrade pas l'électrode métallique **12,** à savoir :
▪ la nature du matériau de la couche **18** qui définit « l'intensité » de l'adhérence entre cette couche **18** et la couche de semi-conducteur **14** ; et
▪ l'épaisseur de la couche **18** qui règle également l'intensité d'un mécanisme, vraisemblablement, comme dit plus haut, de nature vibratoire qui aide au décollement de la couche **14.**

Il a également été observé qu'à adhérence égale, la fluence minimale diminue à mesure que l'absorption du rayonnement laser par la couche **18** augmente.

De manière préférentielle, le matériau de la couche **18** est choisi de façon à adhérer le plus fortement possible à la couche de matériau semi-conducteur de manière à obtenir un différence la plus élevée possible, entre d'une part l'adhérence de cette couche **18** et la couche de matériau semi-conducteur **14**, et d'autre par l'adhérence de la couche **14** avec les autres matériaux sur lesquels elle est déposée, puisque la fluence est réglée par l'épaisseur de la couche **18.** En effet, plus la couche **18** adhère à la couche **14** et plus la fluence minimale nécessaire au décollement de la couche **14** diminue. La gamme des fluences utilisables est ainsi plus élevée.

D'une manière générale, on a observé une diminution de l'énergie nécessaire au décollement dès qu'une couche de matériau plus adhérente est déposée sur une couche à éliminer, cette couche étant elle-même déposée sur un ou plusieurs matériaux.

Par exemple, l'exemple décrit ci-dessus concerne une couche de semi-conducteur organique, mais l'invention fonctionne également avec des couches d'isolant organique, comme par exemple une couche en SiO₂, en TiO₂, ou en Al₂O₃. De même, l'invention fonctionne également avec des électrodes constituées d'un autre matériau conducteur que l'or, comme par exemple des électrodes en Ni, Cu ou en polymère conducteur (par exemple en PDOT). De même, l'invention fonction avec des substrats réalisés avec d'autres types de plastique que le PEN, comme par exemple des substrats en PET (polyéthylène-téréphtalate) ou en Kafton® (à base de polyimide).

On notera que l'exemple de réalisation décrit ci-dessus concerne l'élimination d'une couche déposée sur deux matériaux. On comprendra que l'invention s'applique également au cas de l'élimination d'une couche déposée sur un seul matériau, par exemple, et sans être limitatif, au cas d'une couche de matériau semi-conducteur organique déposée sur un substrat en plastique. En effet, le simple fait de prévoir une couche **18** appropriée a pour effet de réduire l'énergie minimum nécessaire au décollement, ce qui peut s'avérer avantageux, par exemple en termes d'équipement laser et d'optiques.

On notera également que les relations entre les différentes adhérences en jeu ne nécessitent pas d'être établies avant l'irradiation. Ces relations peuvent se réaliser lors de l'application même de l'irradiation sous l'effet de celle-ci, par exemple en raison d'une modification des liaisons entre les différents matériaux. C'est en effet au moment du décollement que ces relations doivent être vérifiées, peu important que ces relations ne soient pas vérifiées avant l'application de l'irradiation.

De même, la nature du matériau de la couche déposée sur la couche à éliminer et/ou son épaisseur peuvent être choisies de manière à obtenir une légère différence, par exemple en raison de coût et de contraintes de fabrication. Dans ce cas, l'énergie minimale nécessaire au décollement sera plus élevée et entrainera vraisemblablement une dégradation d'un des matériaux. Cependant, du seul fait de la baisse, même minime, de l'énergie à apporter, cette dégradation sera donc minimisée par rapport à celle constatée dans l'état de la technique.

## Revendications

1. Procédé de gravure par un faisceau laser de longueur d'onde prédéterminée d'une zone (16) d'une couche (14) d'un premier matériau, ladite zone (16) étant déposée à la surface d'au moins deux deuxièmes matériaux (10, 12), consistant:
▪ à déposer une couche (18) d'un troisième matériau sur la couche (14) de premier matériau, le premier et le troisième matériau présentant une affinité chimique lors de l'application du faisceau laser supérieure à l'affinité chimique lors de ladite application entre le premier matériau et chacun desdits au moins deuxièmes matériaux ; et
▪ à appliquer le faisceau laser sur une zone d'une surface libre de la couche (18) de troisième matériau à l'aplomb de la zone (16) de la couche (14) de premier matériau avec une fluence dudit faisceau laser entrainant le décollement de ladite zone (16), **caractérisé en ce que** le premier matériau est un matériau semi-conducteur organique et les deuxièmes matériaux sont respectivement un matériau plastique et un matériau conducteur.

2. Procédé de gravure par un faisceau laser selon la revendication 1, ***caractérisé* en ce que** le laser est un laser excimère.

3. Procédé de gravure par un faisceau laser selon la revendication 1 ou 2, ***caractérisé* en ce que** l'épaisseur de la couche (18) de troisième matériau est comprise entre 1 nanomètre et 1 micromètre.

4. Procédé de gravure par un faisceau laser selon la revendication 1, 2 ou 3, ***caractérisé* en ce que** la nature et l'épaisseur de la couche (18) de troisième matériau sont choisis en fonction de la fluence du faisceau laser, de la nature du premier matériau et de l'épaisseur de la zone (16) de premier matériau à décoller.

5. Procédé de gravure par un faisceau laser selon la revendication 1, ***caractérisé* en ce que** le matériau semi-conducteur organique est un polymère fluoré, **en ce que** le matériau conducteur est un métal ou un polymère conducteur, et **en ce que** le troisième matériau est un polymère fluoré.

6. Procédé de gravure par un faisceau laser selon l'une quelconque des revendications précédentes, ***caractérisé* en ce que** le matériau conducteur est de l'or ou du PDOT.

7. Procédé de gravure par un faisceau laser selon l'une quelconque des revendications précédentes, ***caractérisé* en ce que** le troisième matériau est du CYTOP® et/ou le premier matériau est du propylsilylethynyl pentacène (TIPS).

8. Procédé de gravure par un faisceau laser selon l'une des revendications précédentes, ***caractérisé* en ce que** le troisième matériau présente une enthalpie de liaison lors de l'application du faisceau laser avec le premier matériau supérieure à 15 kJ.mol⁻¹.

9. Procédé de gravure par un faisceau laser selon les revendications 7 8 et 8 9, ***caractérisé* en ce que** :
▪ l'épaisseur de la couche (18) de polymère fluoré est sensiblement égale à 100 nanomètres ;
▪ l'épaisseur de la couche (14) de premier matériau est sensiblement égale à 100 nanomètres ;
▪ l'épaisseur de la couche de matériau conducteur est sensiblement égale à 30 nanomètres,
▪ la fluence du faisceau laser est inférieure à 50 mJ/cm² ; et
▪ la durée d'irradiation par le faisceau laser est sensiblement égale à 30 nanosecondes.

10. Procédé de gravure par un faisceau laser selon l'une quelconque des revendications précédentes, ***caractérisé* en ce que** le troisième matériau présente une absorption de longueur d'onde du faisceau laser supérieure à celle du premier matériau.

## Patentansprüche

1. Verfahren zum Ätzen eines Bereichs (16) eines Films (14) eines ersten Materials mit einem Laserstrahl mit einer vorbestimmten Wellenlänge, wobei dieser Bereich (16) auf der Oberfläche von mindestens zwei weiteren Materialien (10, 12) abgeschieden wird,
das darin besteht:
▪ einen Film (18) eines dritten Materials auf dem Film (14) des ersten Materials abzuscheiden, wobei das erste und das dritte Material bei Anwenden des Laserstrahls eine chemische Affinität aufweisen, die größer ist als die chemische Affinität während dieser Anwendung zwischen dem ersten Material und jedem der mindestens zwei weiteren Materialien; und
▪ den Laserstrahl auf einen Bereich einer freien Oberfläche des Films (18) aus drittem Material im Lot über dem Bereich (16) des Films (14) aus dem erstem Material anzuwenden, wobei die Fluenz des Laserstrahls die Ablösung dieses Bereichs (16) bewirkt,
**dadurch gekennzeichnet, dass** es sich bei dem ersten Material um ein halbleitendes, organisches Material handelt und bei den weiteren Materialien jeweils um einen Kunststoff und ein leitendes Material.

2. Verfahren zum Ätzen mittels eines Laserstrahls nach Anspruch 1, **dadurch gekennzeichnet, dass** es sich bei dem Laser um einen Excimerlaser handelt.

3. Verfahren zum Ätzen mittels eines Laserstrahls nach Anspruch 1 oder 2, **dadurch gekennzeichnet, dass** die Dicke des Films (18) aus dem dritten Material zwischen 1 Nanometer und 1 Mikrometer beträgt.

4. Verfahren zum Ätzen mittels eines Laserstrahls nach Anspruch 1, 2 oder 3. **dadurch gekennzeichnet, dass** die Art und Dicke des Films (18) aus dem dritten Material entsprechend der Fluenz des Laserstrahls, der Art des ersten Materials und der Dicke des Bereichs (16) des ersten, abzulösenden Materials gewählt werden.

5. Verfahren zum Ätzen mittels eines Laserstrahls nach Anspruch 1, **dadurch gekennzeichnet, dass** es sich bei dem halbleitenden, organischen Material um ein fluorierters Polymer handelt, und dass es sich bei dem leitenden Material um ein Metall oder ein leitendes Polymer handelt, sowie dadurch, dass es sich bei dem dritten Material um ein fluorierters Polymer handelt.

6. Verfahren zum Ätzen mittels eines Laserstrahls nach einem der vorhergehenden Ansprüche, **dadurch gekennzeichnet, dass** es sich bei dem leitenden Material um Gold oder PDOT handelt.

7. Verfahren zum Ätzen mittels eines Laserstrahls nach einem der vorhergehenden Ansprüche, **dadurch gekennzeichnet, dass** es sich bei dem dritten Material um CYTOP® handelt und/ oder das erste Material Propylsilylethynyl-Pentacen (TIPS) ist

8. Verfahren zum Ätzen mittels eines Laserstrahls nach einem der vorhergehenden Ansprüche, **dadurch gekennzeichnet, dass** das dritte Material bei der Anwendung des Laserstrahls eine Bindungsenthalpie mit dem ersten Material von über ä 15 kJ.mol-1 aufweist.

9. Verfahren zum Ätzen mittels eines Laserstrahls nach Anspruch 7 und 8, **dadurch gekennzeichnet, dass**
▪ die Dicke des Films (18) fluorierten Polymers im Wesentlichen gleich 100 Nanometer ist;
▪ die Dicke des Films (14) des ersten Materials im Wesentlichen gleich 100 Nanometer ist;
▪ die Dicke des Films des leitenden Materials im Wesentlichen gleich 30 Nanometer ist,
▪ die Fluenz des Laserstrahls kleiner als 50 mJ/cm² ist; und
▪ die Bestrahlungsdauer durch den Laserstrahl im Wesentlichen gleich 30 Nanosekunden ist.

10. Verfahren zum Ätzen mittels eines Laserstrahls nach einem der vorhergehenden Ansprüche, **dadurch gekennzeichnet, dass** das dritte Material eine Wellenlängenabsorption des Laserstrahls aufweist, die höher ist als die des ersten Materials.

## Claims

1. A method for etching with a laser beam having a predetermined wavelength an area (16) of a layer (14) of a first material, said area (16) being deposited at the surface of at least two second materials (10, 12), consisting
▪ in depositing a layer (18) of a third material on the layer (14) of the first material, the first and the third materials having a chemical affinity on application of the laser beam greater than the chemical affinity during said application between the first material and each of said at least two second materials; and
▪ in applying the laser beam to an area of a free surface of the layer (18) of third material vertically above the area (16) of the layer (14) of first material with a fluence of said laser beam causing the separation of said area (16);
***characterized in that*** the first material is an organic semiconductor material and the second materials respectively are a plastic material and a conductive material

2. The method for etching with a laser beam of claim 1, ***characterized in that*** the laser is an excimer laser.

3. The method for etching with a laser beam of claim 1 or 2, ***characterized in that*** the thickness of the layer (18) of third material ranges between 1 nanometer and 1 micrometer.

4. The method for etching with a laser beam of claim 1, 2, or 3, ***characterized in that*** the nature and the thickness of the layer (18) of third material are selected according to the fluence of the laser beam, to the nature of the first material, and to the thickness of the area (16) of the first material to be separated.

5. The method for etching with a laser beam of claim 1, ***characterized in that*** the organic semiconductor material is a fluorinated polymer, **in that** the conductive material is a metal or a conductive polymer, and **in that** the third material is a fluorinated polymer.

6. The method for etching with a laser beam of any of the preceding claims, ***characterized in that*** the conductive material is gold or PDOT.

7. The method for etching with a laser beam of any of the preceding claims, ***characterized in that*** the third material is CYTOP® and/or the first material is propylsilylethynyl pentacene (TIPS).

8. The method for etching with a laser beam of any of the preceding claims, ***characterized in that*** the third material has a bonding enthalpy on application of the laser beam with the first material greater than 15 kJ.mol⁻¹.

9. The method for etching with a laser beam of claims 7 and 8, ***characterized in that:***
▪ the thickness of the fluorinated polymer layer (18) is substantially equal to 100 nanometers;
▪ the thickness of the layer (14) of first material is substantially equal to 100 nanometers;
▪ the thickness of the layer of conductive material is substantially equal to 30 nanometers;
▪ the fluence of the laser beam is lower than 50 mJ/cm²; and
▪ the time of irradiation by the laser beam is substantially equal to 30 nanoseconds.

10. The method for etching with a laser beam of any of the foregoing claims, ***characterized in that*** the third material has an absorption of the laser beam wavelength greater than the first material.
